# EUROPEAN PATENT APPLICATION

(11) **EP 4 770 369 A1**
(43) Date of publication of application: **01.07.2026**
(21) Application number: 25218731.5
(22) Date of filing: 26.11.2025
(51) Int. Cl.: H10K 59/122, H10K 59/80

(54) **LIGHT EMITTING DISPLAY DEVICE**

(30) Priority: 30.12.2024 KR 20240201468
(71) Applicant: LG Display Co., Ltd., Seoul, 07336 (KR)
(72) Inventor: JO, Yonghee, 10845 Paju-si, Gyeonggi-do (KR); PARK, Hyemin, 10845 Paju-si, Gyeonggi-do (KR); KIM, KyungMin, 10845 Paju-si, Gyeonggi-do (KR); KIM, Seungkyeom, 10845 Paju-si, Gyeonggi-do (KR); PARK, EunJi, 10845 Paju-si, Gyeonggi-do (KR); BAN, MyungHo, 10845 Paju-si, Gyeonggi-do (KR); KIM, Taehyeon, 10845 Paju-si, Gyeonggi-do (KR)
(74) Representative: Viering, Jentschura & Partner mbB Patent- und Rechtsanwälte

(57) **Abstract**

A light emitting display device including a substrate (110) including a plurality of pixels (P); a planarization layer (PL) on the substrate (110) and having a first portion (PL1) surrounding a plurality of pillar-shaped second portions (PL2); an anode electrode (ANO) on the planarization layer (PL); an emission layer (EL) on the anode electrode (ANO); and a cathode electrode (CAT) on the emission layer (EL). Further, the pillar-shaped second portions (PL2) of the planarization layer (PL) have a refractive index corresponding to a refractive index of the cathode electrode (CAT) such that light transmitted by the emission layer (EL) is reflected within a corresponding pillar towards the substrate (110), and the refractive index of the pillar-shaped second portions (PL2) is greater than a refractive index of the first portion (PL1).

## Description

### BACKGROUND

### Field of the Invention

The present disclosure relates to a light emitting display device. In particular, the present disclosure relates to a bottom emission type light emitting display device having micro mirrors to enhance the light extraction efficiency.

### Discussion of the Related Art

Among display devices, light emitting display devices can have the advantages of a wide viewing angle, excellent contrast, and fast response speed. The light emitting elements used in a light emitting display device can have a light emitting layer made of organic or inorganic material between an anode electrode and a cathode electrode. In these light emitting elements, holes are supplied from the anode electrode and electrons are supplied from the cathode electrode, whereafter the electrons and holes combine at the emission layer to generate excitons. As the excitons change from the excited state to the ground state, fluorescent molecules in the emission layer can emit light to express color.

However, some of the light emitted from the emission layer of the light emitting display device may not be emitted to the outside and can be lost due to total reflection within the electrode layer having a high refractive index, or due to total reflection occurring at the interface between the emission layer and the electrodes and/or the interface between the substrate and the air. This can result in a problem of reduced light extraction efficiency.

To overcome these problems, methods are being developed to improve the light extraction efficiency of light emitting devices by forming microlenses or microcavity structures inside the devices. However, although these structures improve the luminous efficiency of light emitted in the vertical direction of the display device, these structures cannot extract light emitted in the horizontal direction to the vertical direction. Therefore, existing methods have limitations in improving light extraction efficiency.

### SUMMARY OF THE DISCLOSURE

The purpose of the present disclosure, as for solving the problems described above, is to provide a bottom emission type light emitting display device that maximizes light extraction efficiency by extracting light generated from the emission layer to the outside, which would otherwise be trapped inside the device and disappear due to total reflection. Another purpose of the present disclosure is to provide a bottom emission type light emitting display device that improves brightness (or luminance) degradation rate and light extraction efficiency by arranging a micro mirror structure on the edge of the light emitting area to maximize the area of the light emitting area. In particular, the present disclosure provides a bottom emission type light emitting display device that improves light extraction efficiency and enhances brightness per power consumption by extracting light that can be extinguished by an electric field from the central portion of the anode electrode to the outside. According to an aspect of the present disclosure, a light emitting display device according to claim 1 is provided. According to another aspect of the present disclosure, a light emitting display device according to claim 14 is provided. Further embodiments are described in the dependent claims.

In order to accomplish the above mentioned purposes of the present disclosure, a light emitting display device according to at least one embodiment of the present disclosure includes: a substrate, a planarization layer, a plurality of pillars, an anode electrode, an emission layer and a cathode electrode. The substrate includes a plurality of pixels. The planarization layer is disposed on the substrate, and includes a flat portion having a predetermined thickness and a protrusion portion extruded upward from the flat portion. The plurality of pillars is arrayed with a predetermined gap inside the protrusion portion. The anode electrode is disposed on an upper surface of the protrusion portion. The emission layer is disposed on the anode electrode. The cathode electrode is disposed on the emission layer.

The light emitting display device according to the present disclosure can have a structure in which almost all of the lights emitted from the emission layer can be extracted to the outside without being trapped and extinguished inside of the device, thereby providing a bottom emission type light emitting display device with maximized light extraction efficiency. The light emitting display device according to the present disclosure can provide a bottom emission type light emitting display device that minimizes non-emission areas and can improve light extraction efficiency by arranging micro mirrors (or reflectors) without using a bank covering the circumferences of the pixel electrode.

With the micro-mirror structure formed at the edge of the anode electrode, the light emitting display device according to the present disclosure can further extract lights that would otherwise be lost within the anode electrode (or, within the light emitting diode). In particular, by implementing a structure in which lights that can be lost within the anode electrode (or, within the light emitting diode) in the central portion of the pixel can be also extracted to the outside, the light extraction efficiency can be further improved. Accordingly, the light emitting display device can provide higher brightness with the same power consumption, or uses lower power consumption to provide the same brightness. Therefore, the light emitting display device according to the present disclosure can be driven at low power consumption. The effects that can be obtained from the present disclosure are not limited to the effects mentioned above, and other effects that are not mentioned can be clearly understood by those skilled in the art to which this disclosure belongs from the description above.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a diagram illustrating a schematic structure of a light emitting display device according to the present disclosure.
FIG. 2 is a circuit diagram illustrating a structure of one pixel included in the light emitting display device according to an example of the present disclosure.
FIG. 3 is a plan view illustrating an arrangement structure of the pixels arrayed in one unit-pixel of the light emitting display device according to an example of the present disclosure.
FIG. 4 is an enlarged cross-sectional view, taken along line I-I' in FIG. 3, for illustrating the structure of a light emitting display device according to an example of the present disclosure.
FIG. 5 is an enlarged cross-sectional view, taken along line II-II' in FIG. 3, for illustrating light paths in a light emitting display device according to an example of the present disclosure.
FIG. 6 is an enlarged cross-sectional view, taken along line II-II' of FIG. 3, illustrating a structure of a light emitting display device according to a first embodiment of the present disclosure.
FIG. 7 is an enlarged plan view, taken along line II-II' of FIG. 3, illustrating a structure of a light emitting display device according to a second embodiment of the present disclosure.
FIG. 8 is an enlarged plan view illustrating a structure of a light emitting display device according to a third embodiment of the present disclosure.
FIG. 9 is an enlarged plan view illustrating a structure of a light emitting display device according to a fourth embodiment of the present disclosure.
FIG. 10 is an enlarged plan view illustrating a structure of a light emitting display device according to a fifth embodiment of the present disclosure.
FIG. 11 is an enlarged cross-sectional view, taken along line III-III' of FIG. 10, illustrating a structure of a light emitting display device according to the fifth embodiment of the present disclosure.
FIG. 12 is an enlarged plan view illustrating a structure of a light emitting display device according to a sixth embodiment of the present disclosure.
FIG. 13 is an enlarged cross-sectional view, taken along line IV-IV' of FIG. 12, illustrating a structure of a light emitting display device according to the sixth embodiment of the present disclosure.

### DETAILED DESCRIPTION OF THE EMBODIMENTS

Advantages and features of the present disclosure, and implementation methods thereof will be clarified through following embodiments described with reference to the accompanying drawings. The present disclosure can, however, be embodied in different forms and should not be construed as limited to the embodiments set forth herein. Rather, these example embodiments are provided so this disclosure can be sufficiently thorough and complete to assist those skilled in the art to fully understand the scope of the present disclosure. Further, the protected scope of the present disclosure is defined by claims and their equivalents.

The shapes, sizes, ratios, angles, numbers, and the like, which are illustrated in the drawings in order to describe various example embodiments of the present disclosure, are merely given by way of example. Therefore, the present disclosure is not limited to the illustrated details. Like reference numerals refer to like elements throughout the specification unless otherwise specified. In the following description, where the detailed description of the relevant known function or configuration can unnecessarily obscure an important point of the present disclosure, a detailed description of such known function of configuration can be omitted.

Reference will now be made in detail to the exemplary embodiments of the present disclosure, examples of which are illustrated in the accompanying drawings. Wherever possible, the same reference numbers will be used throughout the drawings to refer to the same or like parts. In the specification, it should be noted like reference numerals already used to denote like elements in other drawings are used for elements wherever possible. In the following description, when a function and a configuration known to those skilled in the art are irrelevant to a particular configuration of the present disclosure, their detailed descriptions will be omitted. The terms described in the specification should be understood as follows.

In the present specification, where the terms "comprise," "have," "include," and the like are used, one or more other elements can be added unless the term, such as "only," is used. An element described in the singular form is intended to include a plurality of elements, and vice versa, unless the context clearly indicates otherwise. Also, in construing an element, the element is construed as including an error or tolerance range even where no explicit description of such an error or tolerance range is provided.

Further, in the description of the various embodiments of the present disclosure, where positional relationships are described, for example, where the positional relationship between two parts is described using "on," "over," "under," "above," "below," "beside," "next," or the like, one or more other parts can be located between the two parts unless a more limiting term, such as "immediate(ly)," "direct(ly)," or "close(ly)" is used. For example, where an element or layer is disposed "on" another element or layer, a third layer or element can be interposed therebetween. Also, if a first element is described as positioned "on" a second element, it does not necessarily mean the first element is positioned above the second element in the figure. In addition, the upper part and the lower part of an object concerned can be changed depending on the orientation of the object. Consequently, where a first element is described as positioned "on" a second element, the first element can be positioned "below" the second element or "above" the second element in the figure or in an actual configuration, depending on the orientation of the object. Further, in describing a temporal relationship, when the temporal order is described as, for example, "after," "subsequent," "next," or "before," a case which is not continuous can be included unless a more limiting term, such as "just," "immediate(ly)," or "direct(ly)," is used.

In addition, it will be understood that, although the terms "first," "second," and the like can be used herein to describe various elements, these elements should not be limited by these terms as they are not used to define a particular order. These terms are used only to distinguish one element from another. For example, a first element could be termed a second element, and, similarly, a second element could be termed a first element, without departing from the scope of the present disclosure.

Further, in describing various elements in the present disclosure, terms such as first, second, A, B, (a), and (b) may be used. These terms are used merely to distinguish one element from another, and not to define a particular nature, order, sequence, or number of the elements. Where an element is described as being "linked", "coupled," or "connected" to another element, that element may be directly or indirectly connected to that other element unless otherwise specified. It is to be understood that additional element or elements may be "interposed" between the two elements which are described as "linked," "connected," or "coupled" to each other.

Still further, it should be understood the term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in a co-dependent relationship. Hereinafter, an example of a display device according to the present disclosure will be described in detail with reference to the attached drawings. Wherever possible, the same reference numbers will be used throughout the drawings to refer to the same or like parts. Hereinafter, referring to figures, the present disclosure will be explained.

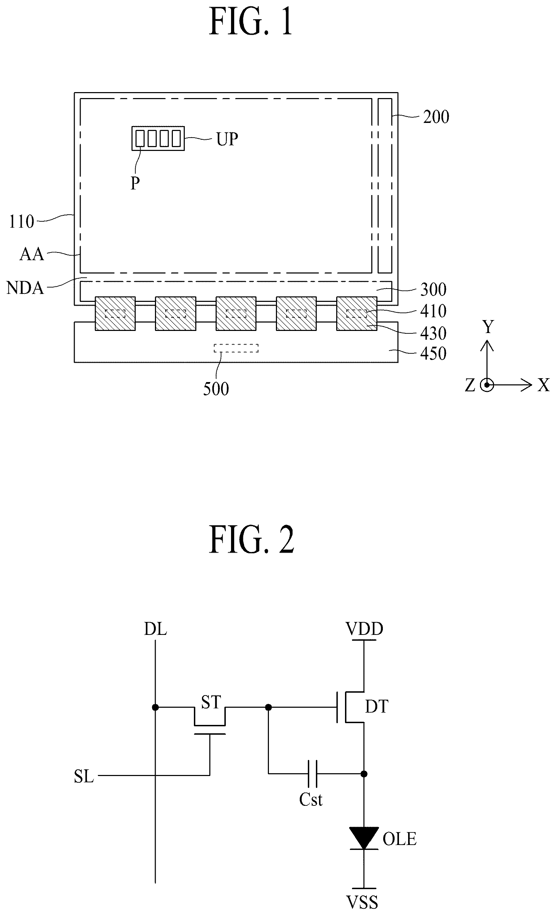

FIG. 1 is a diagram illustrating a schematic structure of a light emitting display device according to the present disclosure. In FIG. 1, the X-axis refers to the (left-right) direction parallel to example scan lines, the Y-axis refers to the (up-down) direction parallel to example data lines, and the Z-axis refers to the height (or thickness) direction of the display device. Referring to FIG. 1, the light emitting display device includes a substrate 110, a gate (or scan) driver 200, a pad portion 300, a source driving IC (Integrated Circuit) 410, a flexible circuit film 430, a circuit board 450, and a timing controller 500.

The substrate 110 may include an electrical insulating material or a flexible material. The substrate 110 may be made of a glass, a metal, or a plastic, but it is not limited thereto. When the light emitting display device is a flexible display, the substrate 110 may be made of the flexible material such as plastic. For example, the substrate 110 may include a transparent polyimide material. The substrate 110 may also include a display area AA and a non-display area NDA.

The display area AA, which is an area for representing the video images, may be defined as the majority middle area of the substrate 110, but it is not limited thereto. In the display area AA, a plurality of scan lines (or gate lines), a plurality of data lines, and a plurality of unit pixels UP may be formed or disposed with the unit pixels UP are arrayed in a matrix manner. Each of unit pixels UP can include a plurality of pixels P, and each of the pixels P can contact at least one respective scan line and data line.

Also, the non-display area NDA, which is an area not displaying video images, may be defined at the circumference areas of the substrate 110 surrounding all or some of the display area AA. In the non-display area NDA, the gate driver 200 and the pad portion 300 may be formed or disposed. The gate driver 200 may supply the scan (or gate) signals to the scan lines according to the gate control signal input through the pad portion 300 from the timing controller 500. Similarly, the gate driver 200 may be formed at the non-display area NDA at any one outside of the display area AA on the substrate 110, as a GIP (Gate driver In Panel) type. The term "GIP type" means the gate driver 200 is directly formed on the substrate 110. For example, the gate driver 200 may be configured as a shift resistor with the term "GIP type" referring to a structure in which transistors for the shift resistor of the gate driver 200 are directly formed on the substrate 110.

Also, the pad portion 300 may supply data signals to data lines according to a data control signal input from the timing controller 500. The pad portion 300 may be formed as a driving chip and mounted the flexible circuit film 430, and the flexible circuit film 430 may be attached to the non-display area NDA of one edge of the display area AA of the substrate 110.

In addition, the source driving IC 410 may receive the digital video data and the source control signal from the timing controller 500, convert the digital video data into the analog data voltages according to the source control signal, and then supply the analog data voltages to the data lines. When the source driving IC 410 is made as a chip type, the source driving IC 410 can be installed on the flexible circuit film 430 as a COF (chip on film) or COP (chip on plastic) type.

Further, the flexible circuit film 430 can include a plurality of first link lines connecting the pad portion 300 to the source driving IC 410, and a plurality of second link lines connecting the pad portion 300 to the circuit board 450. In various examples, the flexible circuit film 430 can be attached on the pad portion 300 using an anisotropic conducting film so the pad portion 300 can be connected to the first link lines of the flexible circuit film 430.

Also, the circuit board 450 can be attached to the flexible circuit film 430 and can include a plurality of circuits implemented as the driving chips. For example, the circuit board 450 can be a printed circuit board or a flexible printed circuit board. The circuit board 450 can also be a printed circuit board or a flexible printed circuit board.

In operation, the timing controller 500 can receive the digital video data and the timing signal from an external system board through the line cables of the circuit board 450. Next, the timing controller 500 can generate a gate control signal for controlling the operation timing of the gate driver 200 and a source control signal for controlling the source driving IC 410, based on the timing signal. Then, the timing controller 500 can supply the gate control signal to the gate driver 200 and supply the source control signal to the source driving IC 410. Depending on the product types, the timing controller 500 can be formed as one chip with the source driving IC 410 and mounted on the substrate 110.

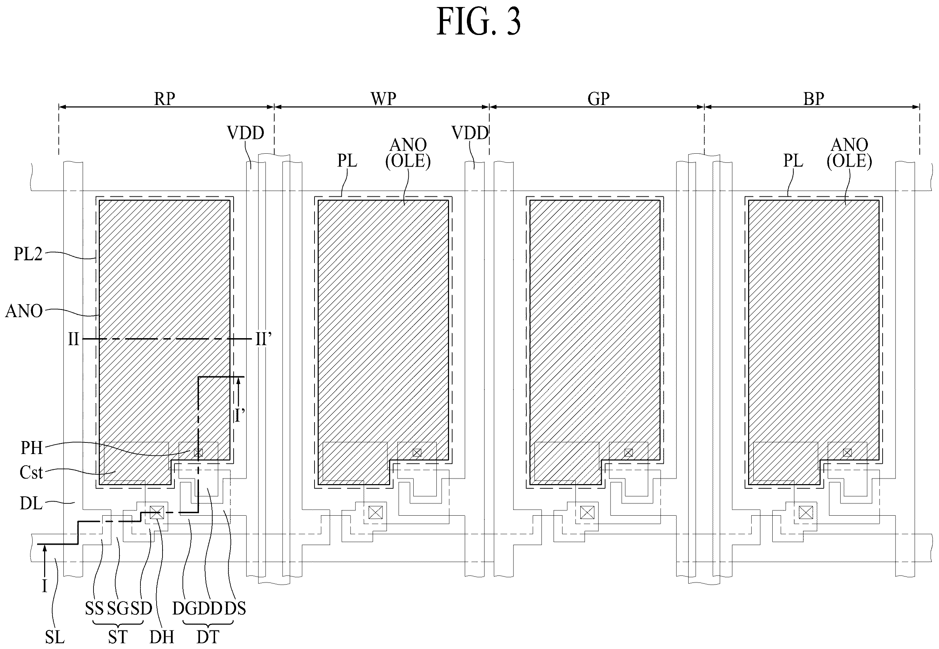

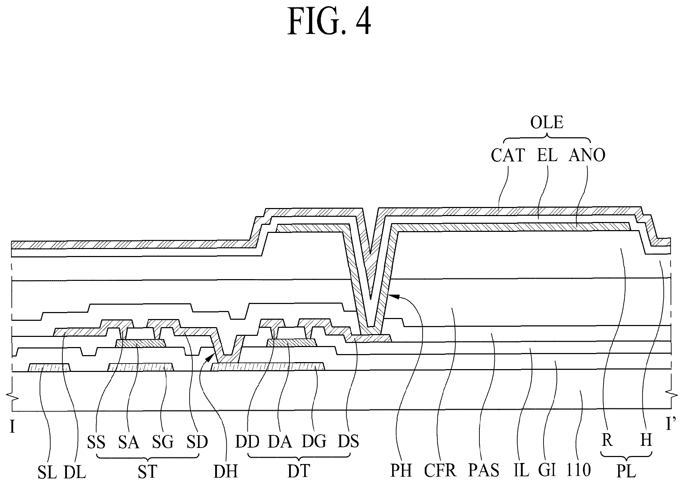

Next, referring to FIGS. 2 to 4, an embodiment of the present disclosure will be explained. FIG. 2 is a circuit diagram illustrating a structure of one pixel included in a pixel area of the light emitting display device. FIG. 3 is a plan view illustrating an arrangement structure of pixels disposed in respective pixel areas in the light emitting display device. FIG. 4 is an enlarged cross-sectional view along to cutting line I-I' in FIG. 3, for illustrating the structure of a light emitting display device.

Again, referring to FIGS. 2 to 4, a light emitting display device includes a plurality of unit pixels UP. Each unit pixel UP of the light emitting display can include three pixels P or four pixels P. For example, one unit pixel P can include a red pixel RP, a green pixel GP, and a blue pixel BP. For another example, as shown in FIG. 3, one unit pixel UP can include one red pixel RP, a white pixel WP, a green pixel GP, and a blue pixel BP.

In the following description, the term "one pixel" of the light emitting display device can be any one of a red pixel RP, a white pixel WP, a green pixel GP, and a blue pixel BP with the one pixel disposed at an intersection of a scan line SL, a data line DL, and a driving current line VDD. As shown in FIG. 2, any one pixel of the light emitting display device can include a switching thin film transistor ST, a driving thin film transistor DT, a light emitting diode OLE, and a capacitor Cst. The driving current line VDD can be supplied with a high-level voltage for driving the light emitting diode OLE. As used below in reference to the drawings, a red pixel RP can include a red light emitting diode OLE, and a red anode electrode ANO.

Next, in the following description referring to FIG. 3, one pixel P can have a structure in which a data line DL is disposed at the left side of the pixel P and a driving current line VDD is disposed at the right side of the pixel P. However, pixels are not limited thereto, and various structures can be acceptable. For example, an example unit-pixel UP can include four pixels P, and the driving current lines VDD can be disposed, respectively, at the left side and the right side of the unit pixel UP. Further, a reference line can be disposed between a white pixel WP and a green pixel GP. In addition, a data line DL can be disposed at each left side of each of the pixels P.

Further, the switching thin film transistor ST shown in FIG. 2 can be disposed at a location where the scan line SL and the data line DL intersect, and can include a gate electrode SG, a semiconductor layer SA, a source electrode SS, and a drain electrode SD. The gate electrode SG can be connected to the scan line SL, the source electrode SS can be connected to the data line DL, and the drain electrode SD can be connected to the driving thin film transistor DT. The semiconductor layer SA of the switching thin film transistor ST can be disposed on a gate insulating layer GI overlapping the gate electrode SG, and the portion of the semiconductor layer SA overlapping the gate electrode SG can be defined as a channel region.

Also, an intermediate insulating layer IL can be deposited on the semiconductor layer SA with the source electrode SS and the drain electrode SD formed on the intermediate insulating layer IL. Further, the source electrode SS can be connected to one side of the semiconductor layer SA via one contact hole formed at the intermediate insulating layer IL, and the drain electrode SD can be connected to another side of the semiconductor layer SA via another contact hole formed at the intermediate insulating layer IL. The switching thin film transistor ST can be used to select a pixel P to be driven by applying a data signal to the driving thin film transistor DT.

In addition, the driving thin film transistor DT can drive the light emitting diode OLE of the pixel selected by the switching thin film transistor ST. Also, the driving thin film transistor DT can include a gate electrode DG, a semiconductor layer DA, a source electrode DS and a drain electrode DD. Further, the gate electrode DG of the driving thin film transistor DT can be connected to the drain electrode SD of the switching thin film transistor ST. For example, the gate electrode DG of the driving thin film transistor DT can be connected to the drain electrode SD of the switching thin film transistor ST via a drain contact hole DH penetrating the gate insulating layer GI covering the gate electrode DG. The drain electrode DD can be connected to the driving current line VDD, and the source electrode DS can be connected to an anode electrode ANO of the light emitting diode OLE. The capacitor Cst can be disposed between the gate electrode DG of the driving thin film transistor DT and the anode electrode ANO of the light emitting diode OLE.

Also, the intermediate insulating layer IL can be deposited on the semiconductor layer DA, and the source electrode DS and the drain electrode DD can be formed on the intermediate insulating layer IL. Also, the source electrode DS can be connected to one side of the semiconductor layer DA via one contact hole formed at the intermediate insulating layer IL while the drain electrode DD can be connected to another side of the semiconductor layer DA via another contact hole formed at the intermediate insulating layer IL.

Further, the driving thin film transistor DT can be disposed between the driving current line VDD and the light emitting diode OLE. The driving thin film transistor DT can control the amount of current flowing from the driving current line VDD to the light emitting diode OLE according to the magnitude of the voltage of the gate electrode DG of the driving thin film transistor DT connected to the drain electrode SD of the switching thin film transistor ST. As shown in FIG. 4, the drain electrode SD of the switching thin film transistor ST is electrically connected to the gate electrode DG of the driving thin film transistor DT through opening DH, which passes through the gate insulating layer GI and the intermediate insulating layer IL.

Next, the light emitting diode OLE can include an anode electrode ANO, an emission layer EL, and a cathode electrode CAT, and can emit lights in response to an electric current controlled by the driving thin film transistor DT. Since the amount of light emitted can be adjusted according to the current controlled by the driving thin film transistor DT, the brightness of the light emitting display device can be controlled. Also, the anode electrode ANO of the light emitting diode OLE can be connected to the source electrode DS of the driving thin film transistor DT, and the cathode electrode CAT can be connected to a low voltage line VSS to which a low potential voltage is applied. Thus, the light emitting diode OLE can be driven by the difference between a low-potential voltage and a high-potential voltage controlled by a driving thin film transistor DT.

In addition, a passivation layer PAS can be deposited on the surface of the substrate 110 having the thin film transistors ST and DT with the passivation layer PAS including an inorganic material such as silicon oxide (SiOx) or silicon nitride (SiNx). As used herein, the layers configuring the thin film transistors ST and DT on the substrate 110 can be called a 'driving element layer.' For example, from the metal layer for the scan line SL and the gate electrodes SG and DG to the passivation layer PAS covering the thin film transistors ST and DT can be defined as the driving element layer.

Further, a color filter CF can be formed on the passivation layer PAS and can disposed on each pixel P. In various examples, the color filter CF can include a red color filter CFR at the red pixel RP, a green color filter at the green pixel GP, and a blue color filter at the blue pixel BP while the white pixel WP has no color filter.

FIG. 4 shows the color filter CF (red color filter CFR in FIG. 4) is extended from the emission area (i.e., an area where an anode ANO, emission layer EL, and cathode CAT overlap) to the non-emission area (i.e., an area where no anode ANO overlaps with both an emission layer EL and cathode CAT). However, pixels are not limited thereto, and the color filter CF can be formed as corresponding to a respective emission area only. Also, a planarization layer PL can be deposited on the color filter CF. The planarization layer PL can be a thin film for making the surface of the substrate 110 on which thin film transistors ST and DT are formed flat. To make even the height difference, the planarization layer PL can be formed of an organic material.

Further, a pixel contact hole PH for exposing a portion of the source electrode DS of the driving thin film transistor DT can be formed as penetrating the passivation layer PAS, the color filter CF, and the planarization layer PL. Also, an anode electrode ANO can be formed on the planarization layer PL with the anode electrode ANO connected to the source electrode DS of the driving thin film transistor DT via the pixel contact hole PH.

As is also shown in FIG. 4, the planarization layer PL can have a level (or step) difference. For example, the planarization layer PL can be patterned using an anode electrode ANO as a mask so the planarization layer PL can have a structure in which some of the planarization layer PL protrudes upward, and the anode electrode ANO is formed on the protruded planarization layer PL. FIG. 4 shows the protrusion portion R of the planarization layer PL can be formed as covering the pixel contact hole PH. However, protrusion portions R are not limited thereto as, in various examples, the protrusion portion R of the planarization layer PL may not cover the pixel contact hole PH. In such a situation, the pixel contact hole PH and the area around the pixel contact hole PH can be included in the non-emission area. For another example in which the planarization layer PL is not patterning, after depositing a first planarization layer on the substrate 110, a second planarization layer can be formed on the first planarization layer as having a protruded (or extruded) island shape. In this situation, the anode electrode ANO can be formed on the second planarization layer.

Also, the anode electrode ANO can have different material depending on the emission type of the light emitting diode OLE. For instance, for a bottom emission type in which the light emitting diode OLE emits to the substrate 110, the anode electrode ANO can be formed of a transparent conductive material. In contrast, for a top emission type in which the light emitting diode OLE emits upward opposing the substrate 110, the anode electrode ANO can be formed of a metal material having excellent light reflectance. In this top emission type situation, the anode electrode ANO can have a structure in which a transparent conductive layer and a metal layer are stacked.

Also, for the bottom emission type situation, the anode electrode ANO can be made of a transparent conductive material (TCO) or semi-transparent conductive material. For instance, the anode electrode ANO can be made of a transparent conductive material such as indium tin oxide (ITO), indium zinc oxide (IZO), or indium zinc tin oxide (IZTO). Otherwise, the anode electrode ANO can be made of a semi-transparent layer of magnesium (Mg), silver (Ag), or an alloy of magnesium (Mg) and silver (Ag) with a thickness of less than 100nm. The example anode electrode ANO can be called a first electrode or a transparent electrode.

Further, an emission layer EL can be deposited on the anode electrode ANO. The emission layer EL can be disposed on the entire surface of the substrate 110 as one sheet type covering continuously the upper surface of the substrate 110. The emission layer EL can include various functional layers stacked each other. For example, the emission layer EL can include a hole functional layer, an organic emission layer, and an electron functional layer. Each of the hole functional layer and the electron functional layer can be deposited on the substrate 110 as continuous sheet, and the organic emission layer can also have a sheet shape between the hole functional layer and the electron functional layer. However, the present disclosure is not limited thereto, and the organic emission layer can be disposed so as to be spaced apart corresponding to each emission area EA of each pixel P.

In addition, the emission layer EL can include two or more emission portions for emitting white color light. For example, the emission layer EL can have a tandem structure in which a first emission layer and a second emission layer are vertically stacked for emitting white color light by mixing a first color light and a second color light. However, the present disclosure is not limited thereto, and the vertically stacked emission portions can include three or four layers.

Next, a cathode electrode CAT can be deposited on the emission layer EL with the cathode electrode CAT disposed as a thin layer shape continuously deposited on the entire surface of the substrate 110. Thus, the stacked structure of the anode electrode ANO, the emission layer EL, and the cathode electrode CAT can constitute the light emitting diode OLE. Further, the cathode electrode CAT, which can be called as a second electrode, reflection electrode, or counter electrode, can be made of a metal material having excellent light reflectance. For example, the cathode electrode CAT may be formed of a metal material with excellent light reflectance with a thickness of at least 2,000Å to 3,000Å (200nm to 300nm). Here, the metal material having excellent light reflectance may include aluminum (Al), magnesium (Mg), calcium (Ca), silver (Ag) ,or alloy thereof (i.e., aluminum-magnesium alloy (AlMg)). In another example, the cathode electrode CAT may include a stack of aluminum and titanium (Ti/Al/Ti), a stack of aluminum and indium tin oxide (ITO/Al/ITO), a silver alloy, or a stack of silver alloy and indium tin oxide (ITO/Ag alloy/ITO). Here, a silver alloy can be an alloy of silver (Ag), palladium (Pd) and copper (Cu).

In addition, the stacked structure of the anode electrode ANO, the emission layer EL and the cathode electrode CAT can constitute the light emitting diode OLE. Also, the light emitting display device can have a structure in which each of light emitting diode OLE is disposed on the planarization layer PL patterned with protruding island shape within the pixel P. From the planarization layer PL deposited on the driving element layer to the cathode electrode CAT of the light emitting diode OLE can be called as a 'light emitting element layer.

In detail, within each pixel P, a planarization layer PL can be applied over the entire surface of the substrate 110, and can have a protrusion portion in the shape of an island with a certain thickness. The anode electrode ANO can be formed on the upper surface of the protrusion portion of the planarization layer PL. The emission layer EL can be deposited to cover the upper surface of the planarization layer PL having steps and the upper surface of the anode electrode ANO. The cathode electrode CAT can be also deposited with the same profile as the emission layer EL. As a result, the cathode electrode CAT can have a cap, '∩', shape facing downward. Since the cathode electrode CAT can be made of a metal material with excellent light reflectance, the cathode electrode CAT can have a structure in which the cap shaped micro mirrors are formed along the protrusion portion of the planarization layer PL.

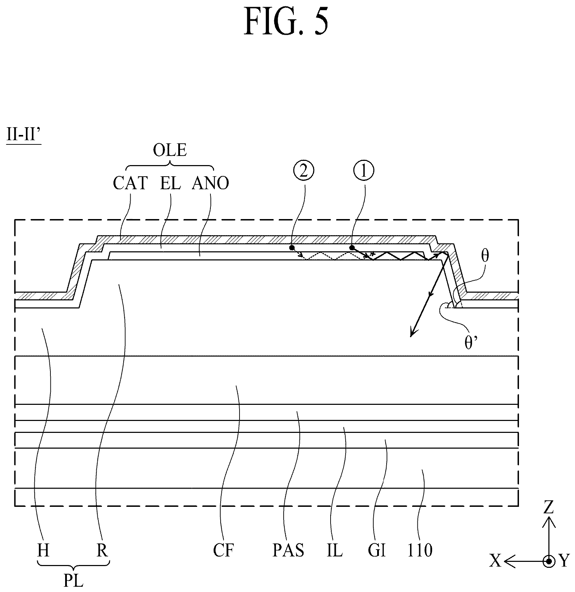

In the situation of a bottom emission type, there can be a disadvantage in the area ratio of the aperture area to the pixel area can be relatively smaller than top emission type, due to the thin film transistor ST and DT, capacitor Cst, and lines SL, DL, and VDD. However, the light emitting display device according to the present disclosure can provide a structure equipped with a micro mirror so light generated from the emission layer EL can be provided toward the substrate 110 placed underneath without loss even though the aperture area is small. Hereinafter, referring to FIG. 5, the mechanism for enhancing the light extraction efficiency by the micro mirror will be explained. FIG. 5 is an enlarged cross-sectional view along to cutting line II-II' in FIG. 3, for illustrating light paths in a light emitting display device according to an example of the present disclosure.

Referring to FIG. 5, the optical path ① for light emitted from the emission layer EL at the edge region of the anode electrode ANO is described. Light emitted from the emission layer EL can be transmitted as a spherical wave, i.e., light can be emitted in all directions 360 degrees on the cross-sectional view. Also, light emitted to the top direction can be reflected by the cathode electrode CAT and travel downward enabling most of the light generated from the emission layer EL can be radiated in a 180-degree downward direction. This light can be incident into the anode electrode ANO, and since the anode electrode ANO can be made of a transparent conductive material, 60% to 70% of the light can pass through the anode electrode ANO, can pass through the color filter CF placed underneath, and can be emitted outside the substrate 110.

Further, the anode electrode ANO can be a transparent conductive material with a refractive index of 2.0 to 2.3. Assuming the upper surface of the anode electrode ANO is in contact with the emission layer EL, the bottom surface of the anode electrode ANO is in contact with the planarization layer PL, and the emission layer EL and the planarization layer PL have a refractive index of 1.3 to 1.5, a structure can be formed in which an anode electrode ANO with a high refractive index is interposed between two low refractive index layers. Therefore, among the light incident into the anode electrode ANO, 30% to 40% of the light can be propagated in the horizontal direction (X-axis direction) inside the anode electrode ANO.

In addition, the refractive index of the emission layer EL can be similar to the refractive index of the anode electrode ANO. In this situation, among the light emitted from the emission layer EL, the light reflected at the interface between the anode electrode ANO and the planarization layer PL can be trapped between the cathode electrode CAT and the planarization layer PL, and so such light can propagate in the horizontal direction (X-axis direction). The light propagating horizontally within the anode electrode ANO, or between the cathode electrode CAT and the planarization layer PL, can then be emitted from the end of the anode electrode ANO and be reflected by the cathode electrode CAT having the micro mirror structure to be directed downward. When there is no micro mirror structure formed by the protrusion portion of the planarization layer PL, the lights can be propagated horizontally and thus be extinguished. However, according to this structure, the lights can be extracted downward by the micro mirror, thereby improving the light extraction efficiency.

Here, it is explained light propagating in the horizontal direction can propagate while repeating the total reflection process inside the anode electrode ANO. However, the present disclosure is not limited thereto. The lights propagating in the horizontal direction can propagate while repeating the total reflection process inside a structure including the anode electrode ANO and emission layer EL, i.e., between the cathode electrode CAT and the planarization layer PL. For convenience, in this disclosure, it is explained the light can be totally reflected inside the light emitting diode OLE and can be propagated in the horizontal direction.

Here, in order to ensure the lights reflected by the cathode electrode CAT having a micro mirror structure can be emitted to the downward direction properly, it is useful to adjust the angle of the inclination of the cathode electrode CAT deposited on the etched side where the step of the planarization layer PL is formed. For example, the angle θ of the inclined surface of the cathode electrode CAT with respect to the horizontal surface of the substrate 110 can advantageously be in the range of 40 degrees to 80 degrees. More advantageously, the inclination angle θ can be in the range of 50 degrees to 75 degrees. Since the cathode electrode CAT is deposited along the step shape of the planarization layer PL, the inclination angle θ of the cathode electrode CAT can be substantially equal to the side wall inclination angle θ' of the protrusion portion at the planarization layer PL. Therefore, it is more advantageous to form the inclination angle θ' of the side wall of the protrusion portion to be 50 degrees to 75 degrees.

In addition, the light emitting display device according to the present disclosure can include the cathode electrode CAT having the micro mirror structure according to the shape of the planarization layer PL having a protrusion portion R extruded as an island upward from the flat portion H. The planarization layer PL may be a transparent planarization layer, and the flat portion H may have a predetermined thickness (or height). Therefore, the light extraction efficiency can be improved by extracting the light which would otherwise be lost inside the light emitting diode OLE among the light generated from the emission layer EL. Thus, the light extraction efficiency can be improved. The anode electrode ANO may extend along an upper surface of the protruding portion R without extending beyond edges of the protruding portion R. The emission layer EL may cover the anode electrode ANO and extend onto the flat portion H of the planarization layer PL. The cathode electrode CAT may cover the emission layer EL and extend onto the flat portion H of the planarization layer PL. The cathode electrode CAT may be in surface contact with the emission layer EL.

Here, for convenience of explanation, based on one pixel, the planarization layer PL can be described as a structure in which a protrusion portion R is formed on a flat portion H. However, when considering the structure in which a large number of pixels are arranged in a matrix manner, the planarization layer PL can also be described as having a structure in which protrusion portions R and depression portions (corresponding to the flat portions H) are repeatedly arranged. In this situation, the protrusion portions can correspond to the emission areas within each pixel, and the depressed portions can correspond to the non-emission areas surrounding the emission areas.

As stated above, the light emitting display device having the micro mirror structure described above can extract light to the outside of the light emitting diode OLE which would otherwise be trapped and extinguished within the light emitting diode OLE. However, light emitted from the emission layer EL at the central region of the light emitting diode OLE may not be extracted to the outside in such a manner. With reference to FIG. 5, the optical path ② for light emitted from the emission layer EL at the central region of the light emitting diode OLE is discussed. As is described above, light generated from the emission layer EL can be radiated 180 degree downward. Since the anode electrode ANO is made of a transparent conductive material, 60% to 70% of the lights can pass through the anode electrode ANO, pass through the color filter CF placed underneath, and then be emitted outside the substrate 110.

However, among the light incident into the anode electrode ANO, 30% to 40% of the light satisfying total reflection condition can be propagated in the horizontal direction (X-axis direction) inside the anode electrode ANO (or, inside the light emitting diode OLE). In particular, the lights generated at the central region of the pixel can undergo a total reflection process inside the anode electrode ANO, so that the length of the propagating optical path ② can be much longer than the length of the optical path ① described above. Therefore, light can be dissipated as heat energy inside the anode electrode ANO before being emitted through the end of the anode electrode ANO. In general, when light propagates over a length of 20 *µ*m or more inside the anode electrode ANO, such light can be extinguished or annihilated.

Hereinafter, various embodiments are described in which light emitted from an emission layer EL in the middle portion (as seen in plan view) of the light emitting diode OLE in a light emitting display device can be extracted to the outside before being lost or extinguished. In the following explanation, the description for driving element layer which is a common element will not be duplicated. Further, the configuration of the driving element layer is not limited to the explanation mentioned as referring to FIGS. 2 to 4. The configuration of the thin film transistors ST and DT can have any one structure of top gate structure, bottom gate structure, and double gate structure. The thin film transistors ST and DT can include oxide semiconductor material. For example, the material for the semiconductor layers SA and DA can include a metal oxide material such as indium gallium zinc oxide (IGZO). However, the present disclosure is not limited thereto, and the semiconductor layers SA and DA can include any one of an amorphous silicon (a-Si), a polycrystalline silicon (Poly Si), and a low temperature polycrystalline silicon (LTPS).

In addition, the arrangement of the signal lines including scan line SL, data line DL, and driving current line VDD can be varied. Other signal lines including reference line can be further included. In the following description, drawing numeric symbols which are shown in the drawings but not explained can be referred to the description of the drawing numeric symbols in Figs. 2 to 4.

### <First Embodiment>

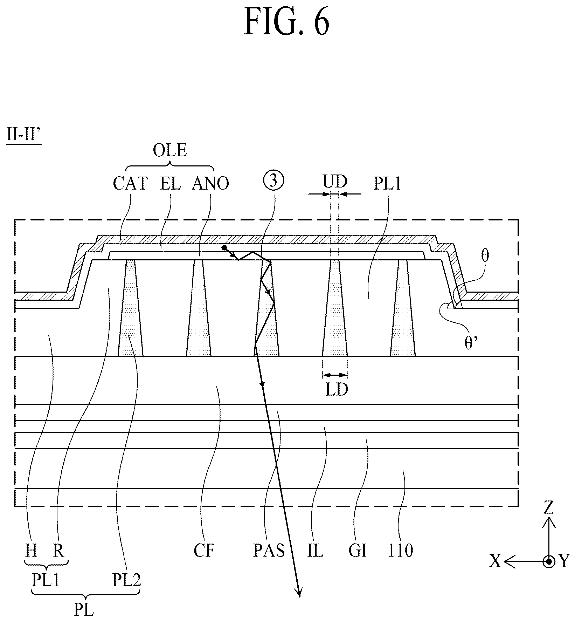

Hereinafter, referring to FIG. 6, a structure of a light emitting display device according to a first embodiment will be explained. FIG. 6 is an enlarged cross-sectional view, taken along line II-II' of FIG. 3, illustrating a structure of a light emitting display device according to a first embodiment. Referring to FIG. 6, a light emitting display device according to a first embodiment can include a gate insulating layer GI, an intermediate insulating layer IL, and a passivation layer PAS can be sequentially stacked on a substrate 110. Also, a color filter CF can be disposed on the passivation layer PAS and a first planarization layer PL1 can be disposed on the color filter CF. The color filter CF may directly contact the first planarization layer PL1 and the second planarization layer PL2.

The first planarization layer PL1 can have a flat portion H and a protrusion portion R with the flat portion H arranged outside the emission area where the anode electrode ANO is formed. In contrast, the protrusion portion R can be arranged at an emission area disposed above the flat portion H with an anode electrode ANO formed on an upper surface of the protrusion portion R. In addition, an emission layer EL and a cathode electrode CAT are sequentially stacked on the anode electrode ANO with the emission layer EL and the cathode electrode CAT deposited as covering the flat portion H and the protrusion portion R of the first planarization layer PL1.

In more detail, the protrusion portion R of the first planarization layer PL1 corresponding to the anode electrode ANO can be patterned to have removed portions (pillars) with regular intervals, and the removed portions can be filled with a second planarization layer PL2. That is, the planarization layer PL disposed under the anode electrode ANO can have a structure in which a first planarization layer PL1 and a second planarization layer PL2 can be alternately arranged at a certain interval. The anode electrode ANO may be directly over the first planarization layer PL1 and the second planarization layer PL2. The anode electrode ANO may be in direct contact with an upper surface of the first planarization layer PL1 and an upper surface of the second planarization layer PL2. Accordingly, the second planarization layer PL2 can have the same thickness with the protrusion portion R of the first planarization layer PL1. For the purposes of this disclosure, the terms "first planarization layer" and "second planarization layer" collectively can be referred to as a "planarization layer." Also, the term "first planarization layer" alternatively can be referred to as a "first portion" of a planarization layer while the term "second planarization layer" alternatively can be referred to as a "second portion" of a planarization layer.

In various examples, the second planarization layer PL2 can have a refractive index higher than that of the first planarization layer PL1. For example, the first planarization layer PL1 can be made of a transparent organic material having a refractive index in range of 1.3 to 1.5 whereas the second planarization layer PL2 can be made of a transparent organic material having a refractive index the same as or as much as 0.2 lower than the anode electrode ANO, and higher than that of the first planarization layer PL1. In other words, a refractive index of the anode ANO is closer to the refractive index of the second planarization layer PL2 (also referred to as the "second refractive index") than the refractive index of the first planarization layer PL1 (also referred to as the "first refractive index"). Under this condition, the light provided from the emission layer EL can emitted along optical path ③. Thus, light provided from the emission layer EL can be radiated downward 180 degrees by the same mechanism described above. Also, assuming the anode electrode ANO can be made of a transparent conductive material, and the second planarization layer PL2 can have a refractive index similar to that of the anode electrode ANO, light that can be totally reflected inside the anode electrode ANO may not directed downward into the second planarization layer PL2.

In the cross-sectional view of FIG. 6, the pillar-shaped second planarization layer PL2 can be surrounded by the first planarization layer PL1. That is, the second planarization layer PL2, which is a high-refractive index material, is surrounded by the first planarization layer PL1, which is a low-refractive index material. This structure can be the same with an optical fiber, so the lights incident into the second planarization layer PL2, a high-refractive index material, can be induced along the length direction (the height direction in FIG. 6) of the second planarization layer PL2 due to the total reflection within the second planarization layer PL2. Accordingly, lights incident through the upper surface of the second planarization layer PL2 can be emitted to the lower surface of the second planarization layer PL2 through a total reflection process inside the second planarization layer PL2. The pillar-shaped second planarization layer PL2 may include a refractive index corresponding to a refractive index of the anode electrode ANO such that light transmitted by the emission layer EL may reflect within a corresponding pillar towards the substrate 110. Each of the pillar-shaped second planarization layer PL2 may have a same length as a thickness of the protrusion portion R. In another example, each of the pillar-shaped second planarization layer PL2 may have a length smaller than a thickness of the protrusion portion R.

Also, among light emitted from the emission layer EL at the central region of the anode electrode ANO (or light emitting diode OLE), 20% to 30% of the light can propagate laterally (horizontally or on the X-axis direction) and then be extinguished while repeating the reflection process inside the anode electrode ANO. However, the second planarization layer PL2 can have a refractive index higher than that of the first planarization layer PL1 and similar to that of the anode electrode ANO, and can be patterned in a pillar shape inserted inside the first planarization layer PL1. Further, the second planarization layer PL2 can have a plurality of pillar structures surrounded by the first planarization layer PL1. The refractive index of the second planarization layer PL2 can be similar to the refractive index of the anode electrode ANO, for example, a refractive index within 0.2 difference of the refractive index with that of the anode electrode ANO. Accordingly, light that would otherwise be totally reflected within the anode electrode ANO can be directed downward and enter into the second planarization layer PL2. Further, as the second planarization layer PL2 can have a refractive index higher than that of the first planarization layer PL1, the light incident from the upper end surface UD of the second planarization layer PL2 can guided to the lower end surface LD through total reflection within the second planarization layer PL2. Consequently, the light that can be lost due to total reflection inside the anode electrode ANO can be extracted to the color filter CF through the second planarization layer PL2.

Further, the second planarization layer PL2 can have a columnar shape in which the width (or, size or area) of the upper end surface UD and the width (or size or area) of the lower end surface LD can be the same. In another example, the second planarization layer PL2 can have a columnar shape with a tapered structure in which the width of the upper end surface UD can be narrower than the width of the lower end surface LD, and the width gradually increased toward the bottom. In still another example, the second planarization layer PL2 can have a columnar shape with a reverse-tapered structure in which the width of the upper end surface UD can be wider than the width of the lower end surface LD, and the width gradually decreased toward the bottom.

In the situation where the second planarization layer PL2 has a tapered structure, the light incident from the upper end surface UD can have gradually widened diffusion angle as the light progresses toward the lower end surface LD. Therefore, the light emitted through the color filter CF can have a widened viewing angle. Accordingly, luminance at the viewing angle direction can be enhanced. In the situation where the second planarization layer PL2 has a reverse-tapered structure, the light incident from the upper end surface UD can have gradually narrowed diffusion angle as the light progresses toward the lower end surface LD. Therefore, the light emitted through the color filter CF can have a narrow viewing angle, and luminance at the frontal direction can be enhanced.

In sum, the first embodiment can provide a bottom emission type light emitting display device having an enhanced light extraction efficiency due to the micro mirror structure. Further, the light emitting display device according to the first embodiment can have higher luminance with the same power consumption. In other words, since the power consumption required to provide the same luminance (or brightness) can be lowered, the light emitting display device according to the first embodiment can be driven with low power consumption.

### <Second Embodiment>

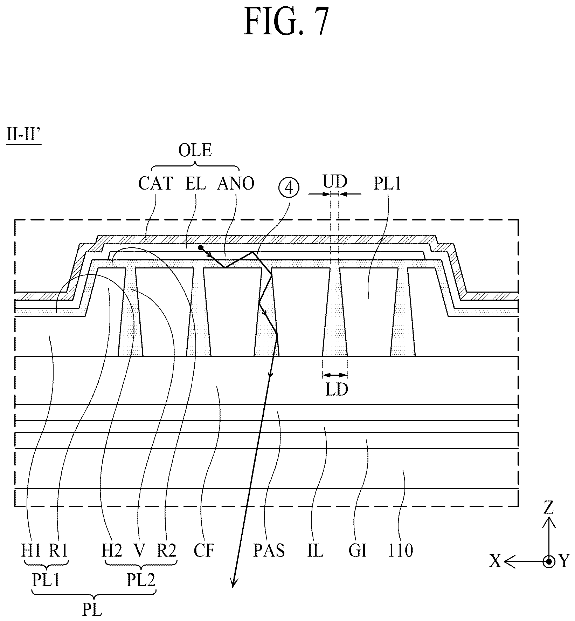

Hereinafter, referring to FIG. 7, a light emitting display device according to a second embodiment will be explained. FIG. 7 is an enlarged plan view, taken along line II-II' of FIG. 3, illustrating a structure of a light emitting display device according to a second embodiment. Referring to FIG. 7, a light emitting display device according to a second embodiment can include a gate insulating layer GI, an intermediate insulating layer IL and a passivation layer PAS sequentially deposited on a substrate 110. A color filter CF can be deposited on the passivation layer PAS, and a first planarization layer PL1 can be deposited on the color filter CF.

As is shown in FIG. 7, the first planarization layer PL1 can include a first flat portion H1 and a first protrusion portion R1. The first flat portion H1 can be arranged outside the emission area where the anode electrode ANO is formed while the first protrusion portion R1 can be arranged at the emission area extruded above the first flat portion H1. A second planarization layer PL2 can be deposited on the first planarization layer PL1. In particular, the first protrusion portion R1 of the first planarization layer PL1 can be patterned to have removed portions with regular intervals, and the removed portions of the first planarization layer PL1 can then be filled with a second planarization layer PL2. The first protrusion portion R1 may overlap upper surfaces of the second planarization layer PL2.

Also, the second planarization layer PL2 can include a second flat portion H2, a second protrusion portion R2, and a vertical pillar V. The second flat portion H2 can be stacked on the first flat portion H1, the second protrusion portion R2 can be stacked on the first protrusion portion R1, and the vertical pillar V can fill into the removed portions of the first protrusion portion R1. The height of the vertical pillar V can correspond to the height of the first protrusion portion R1 of the first planarization layer PL1.

Further, an anode electrode ANO can be formed on the upper surface of the second protrusion portion R2 of the second planarization layer PL2, and an emission layer EL and a cathode electrode CAT can be sequentially stacked on the anode electrode ANO. The emission layer EL and the cathode electrode CAT can also be deposited as covering the first flat portion H1 and the first protrusion portion R1, of the first planarization layer PL1, and the second flat portion H2, the second protrusion portion R2, and the vertical pillar(s) V of the second planarization layer PL2. Accordingly, the planarization layer PL disposed under the anode electrode ANO can have a structure in which the second planarization layer PL2 can be stacked on the first planarization layer PL1, with the first protrusion portion R1, and the second planarization layer PL2 alternately arranged at a certain interval.

It is to be appreciated that the light emitting display device according to the second embodiment can have a structure very similar to that of the first embodiment with a difference being the second embodiment can have a structure in which the second planarization layer PL2 can be deposited on entire surface of the first planarization layer PL1. That is, the second planarization layer PL2 can be stacked on the upper surface of the first planarization layer PL1, and can include a plurality of vertical pillars V penetrating some of the first planarization layer PL1.

Also, in the first embodiment, the anode electrode ANO and the second planarization layer PL2 may not be completely in surface contact with each other at the interface between the anode electrode ANO and the second planarization layer PL2 because a portion of the first planarization layer PL1 makes contact with the anode electrode ANO. Accordingly, light which might be totally reflected inside the anode electrode ANO while not incident into the upper end surface UD of the second planarization layer PL2 can be reflected but with less efficiency. In order to ensure the surface contact between the anode electrode ANO and the second planarization layer PL2, the second planarization layer PL2 can be deposited between the anode electrode ANO and the first planarization layer PL1 with the second planarization layer PL2 including a plurality of vertical pillars V penetrating the first planarization layer PL1. The second planarization layer PL2 above the vertical pillars V may directly contact the anode electrode ANO and separate the anode electrode ANO from the first planarization layer PL1 such that the anode electrode ANO may be spaced apart from the first planarization layer PL1.

In addition, the second planarization layer PL2 can have a refractive index higher than that of the first planarization layer PL1. For example, the second planarization layer PL2 can be made of a transparent organic material having a refractive index having a refractive index the same as or as much as 0.2 lower than the anode electrode ANO, and light provided from the emission layer EL can emitted in the same way as optical path ④. Thus, light provided from the emission layer EL can be radiated downward 180 degrees by the same mechanism described above assuming the anode electrode ANO is made of a transparent conductive material, and the second planarization layer PL2 has a refractive index similar to that of the anode electrode ANO. This is because light can be reflected inside the anode electrode ANO while a portion of light reflected at the interface with the second planarization layer PL2 can be directed into the second planarization layer PL2.

Further, as can be seen in FIG. 7, lower surfaces of the second protrusion portion R2 can be in surface contact with the first protrusion portion R1 of the first planarization layer PL1. Therefore, total reflection can occur at the interface where the first protrusion portion R1 and the second protrusion portion R2 are in surface contact with each other whereas light that does not undergo total reflection can travel downward and pass through the color filter CF to be emitted to the outside. Meanwhile, some light can propagate horizontally along the anode electrode ANO and the second planarization layer PL2. Such light travelling in a horizontal direction can be incident into the upper end surface UD of the vertical pillar V, which can be surrounded by the first planarization layer PL1. Thus, the vertical pillar V of the second planarization layer PL2, which is made of a high-refractive index material and surrounded by the first planarization layer PL1, which is made of a low-refractive index material, resembles the structure of an optical fiber. Accordingly, light incident into the vertical pillar V can be induced along the length direction of the second planarization layer PL2 due to reflection within the vertical pillar V of the second planarization layer PL2. Thereafter, light incident through the upper end surface UD of the second planarization layer PL2 can be emitted to the lower end surface LD of the second planarization layer PL2 through a total reflection process inside the second planarization layer PL2. Consequently, like the first embodiment, the light that might otherwise be lost inside the anode electrode ANO can be extracted to the color filter CF through the second planarization layer PL2. Thus, the second embodiment can provide a bottom emission type light emitting display device having an enhanced light extraction efficiency due to the micro mirror structure. In addition, the light emitting display device according to the second embodiment can extract the lights that can be diminished at the middle portions of the anode electrode ANO, by arranging a plurality of vertical pillars V having higher refractive index in the first planarization layer PL1 having lower refractive index. Accordingly, the light emitting display device according to the second embodiment can have higher luminance with the same power consumption. In other words, since the power consumption required to provide the same luminance (or brightness) can be lowered, the light emitting display device according to the second embodiment can be driven with low power consumption.

### <Third Embodiment>

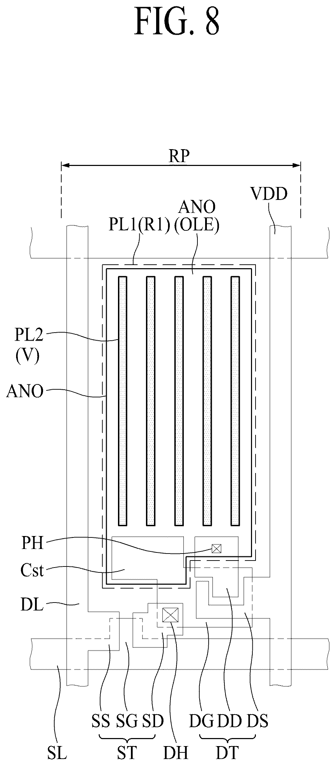

Hereinafter, referring to FIG. 8, a light emitting display device according to a third embodiment will be explained. FIG. 8 is an enlarged plan view illustrating a structure of a light emitting display device according to a third embodiment. FIG. 8 shows a structure in which a second planarization layer PL2 can be patterned within a first planarization layer PL1 in a plan view. Referring to FIG. 8, in a plan view, a vertical pillar V of the second planarization layer PL2 can have a predetermined length along the vertical direction (Y-axis direction) and a predetermined width along the horizontal direction (X-axis direction) in the red pixel RP. Further, a plurality of vertical pillars V can be arrayed at regular intervals along the horizontal direction (X-axis direction). For example, 5 to 10 vertical pillars V can be arrayed along the horizontal direction. In various examples, each vertical pillar V can have a predetermined length along the horizontal direction (X-axis direction) and a predetermined width along the vertical direction (Y-axis direction), in the red pixel RP. However, in other examples, each of the plurality of vertical pillars V can be arrayed at regular intervals along the vertical direction (Y-axis direction) or in an incline direction.

### <Fourth Embodiment>

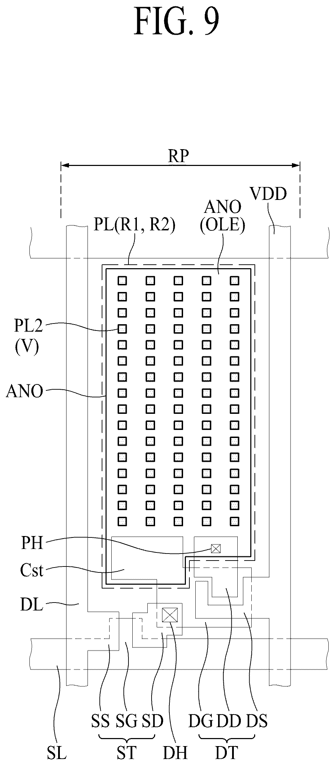

Hereinafter, referring to FIG. 9, a light emitting display device according to a fourth embodiment will be explained. FIG. 9 is an enlarged plan view showing a structure in which a second planarization layer PL2 can be patterned within a first planarization layer PL1 in a plan view. Referring to FIG. 9, each vertical pillar V can have a predetermined length along the horizontal direction (X-axis direction) and a predetermined width along the vertical direction (Y-axis direction), in the red pixel RP, and in the example of FIG. 9 each vertical pillar V can have a rectangular shape having a length and a width within a pixel in a plan view in which the length may be the same as the width, and vertical pillars V may be arranged apart from each other. Further, a plurality of vertical pillars V can be arrayed at regular intervals along the horizontal direction (X-axis direction) and the vertical direction (Y-axis direction). For example, tens of vertical pillars V can be arrayed in a matrix manner within the emission area of the anode electrode ANO.

In FIG. 9, only the red pixel RP is illustrated, but the vertical pillars V of any given second planarization layer PL2 can be arranged in the same manner, such as being on the green pixel GP and the blue pixel BP. In addition, the vertical pillars of the second planarization layer PL2 formed on each of the red pixel RP, the green pixel GP, and the blue pixel BP can have different shapes. The vertical pillars may each include a rectangular ring shape with a width within a pixel in a plan view. The vertical pillars may each include a square shape having a length and a width within a pixel in a plan view, and the vertical pillars may be arranged in a matrix with a predetermined gap. When the number of the vertical pillars of the second planarization layer PL2 is large, more lights that would otherwise be trapped and extinguished inside the anode electrode ANO can be extracted to the outside. Therefore, it can be preferable to form a second planarization layer PL2 having a vertical pillar having a structure shown in FIG. 9 in the blue pixel BP having lower luminance than other pixels.

Still further, other patterns of the second planarization layer PL2 can be implemented. For example, as might be seen in plan view, the second planarization layer PL2 may take the form of circles, "T" shapes, "V" shapes, "X" shapes, "0" shapes (i.e., cylinders), "L" shapes, equilateral crosses, star shaped, hex shaped, or any combination thereof. In addition, in various examples, different color pixels can employ different shaped patterns of the second planarization layer PL2, patterns of the second planarization layer PL2 having the same shape but of different sizes, and patterns of the same shape but of different arrangements or densities. For example, a plan view pattern of second planarization layers PL2 for blue pixels can be an array of 10-by-5 circles while a plan view pattern of second planarization layers PL2 for red pixels can be an array of 6-by-3 circles of the same or different size. Still further, the second planarization layer PL2 may be patterned as concentric circles, concentric squares, concentric rectangles, concentric hexagons, or any other concentric closed polygon.

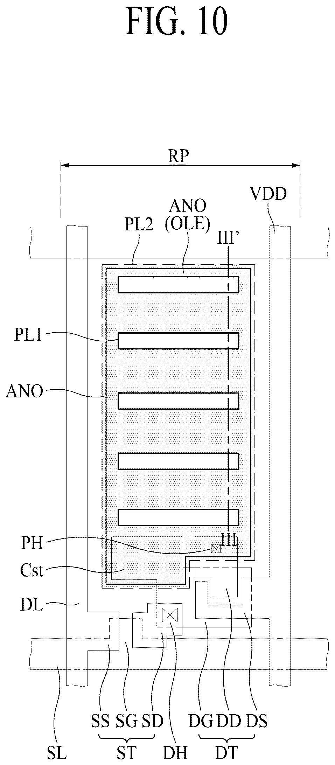

The embodiments described so far have explained various examples in which a first planarization layer PL1 having lower refractive index is applied to entire surface of the substrate 110, and a second planarization layer PL2 having higher refractive index is formed in a pillar shape, so that light emitted from a light emitting diode OLE can be extracted toward the substrate 110 along the pillar of the second planarization layer PL2. Hereinafter, referring to FIGS. 10 to 13, various embodiments can be explained in which a second planarization layer PL2 having higher refractive index can be applied through entire surface of the substrate 110, and a first planarization layer PL1 having lower refractive index is formed in a pillar shape, so that the light emitted from a light emitting diode OLE can be extracted toward the substrate 110 along the second planarization layer PL2.

### <Fifth Embodiment>

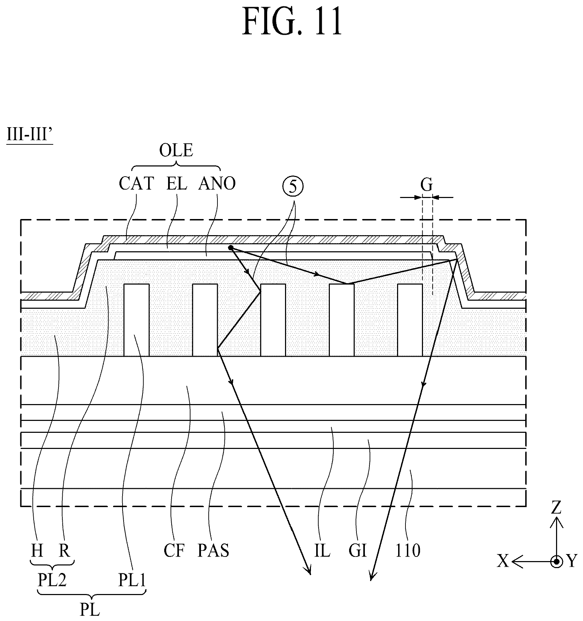

Now referring to FIGS. 10 and 11, a light emitting display device according to a fifth embodiment will be explained. FIG. 10 is an enlarged plan view illustrating a structure of a light emitting display device according to a fifth embodiment. FIG. 11 is an enlarged cross-sectional view, taken along line III-III' of FIG. 10, illustrating a structure of a light emitting display device according to the fifth embodiment. As shown in FIGS. 10 and 11, a light emitting display device according to a fifth embodiment can include a gate insulating layer GI, an intermediate insulating layer IL and a passivation layer PAS sequentially deposited on a substrate 110. A color filter CF can be deposited on the passivation layer PAS, and a planarization layer PL can be deposited on the color filter CF. Between the passivation layer PAS and the substrate 110, a switching thin film transistor ST and a driving thin film transistor DT can be formed as shown in FIG. 4. A light emitting diode OLE can be formed on the planarization layer PL with the light emitting diode OLE including an anode electrode ANO, an emission layer EL, and a cathode electrode CAT.

As is shown in FIGS. 10 and 11, the planarization layer PL can include a first planarization layer PL1 and a second planarization layer PL2. The first planarization layer PL1 can be formed as an island shape on the color filter CF and under the anode electrode ANO. In particular, in a plan view, the first planarization layer PL1 can be configured with a plurality of segments arrayed within the anode electrode ANO. For example, the first planarization layer PL1 can include at least two segments disposed near to the edge sides of the anode electrode ANO. In addition, between at least two segments, at least one segment can be further disposed.

Further, the second planarization layer PL2 can completely cover the first planarization layer PL1, and entire display area on the upper surface of the substrate 110. The second planarization layer PL2 can include a flat portion H and a protrusion portion R. The flat portion H can be arranged outside the emission area where the anode electrode ANO is formed, and the protrusion portion R can be arranged at the emission area extruded above the flat portion H. Accordingly, the first planarization layer PL1 can be arranged as a plurality of island shapes at the interior area of the protrusion portion R of the second planarization layer PL2.

Still further, an anode electrode ANO can be formed on the upper surface of the protrusion portion R of the second planarization layer PL2 with an emission layer EL and a cathode electrode CAT sequentially stacked on the anode electrode ANO. Also, the emission layer EL and the cathode electrode CAT can be deposited as covering the flat portion H and the protrusion portion R of the second planarization layer PL2. The light emitting display device according to the fifth embodiment can have a structure in which the second planarization layer PL2 can cover the first planarization layer PL1. In detail, the first planarization layer PL1 patterned as the island shape can be arrayed under the anode electrode ANO, and the second planarization layer PL2 can be deposited as covering entire of the first planarization layer PL1.

In addition, the second planarization layer PL2 can have a refractive index higher than that of the first planarization layer PL1. For example, the first planarization layer PL1 can be made of a transparent organic material having a refractive index in range of 1.3 to 1.5 while the second planarization layer PL2 can be made of a transparent organic material having a refractive index having a refractive index the same as or as much as 0.2 lower than the anode electrode ANO and higher than that of the first planarization layer PL1. Under these conditions, the light provided from the emission layer EL can be emitted along optical path(s) ⑤. Accordingly, light provided from the emission layer EL can be radiated downward 180 degrees. Assuming the anode electrode ANO can be made of a transparent conductive material, and the second planarization layer PL2 can have a refractive index similar to that of the anode electrode ANO, light that might otherwise be totally reflected inside the anode electrode ANO and eventually extinguished can be channeled into the second planarization layer PL2.

As is also shown in FIGS. 10 and 11, the first planarization layer PL1 can be disposed as one or more island shaped regions under the protrusion portion R of the second planarization layer PL2. Among light incident on the upper surface of the first planarization layer PL1, some light can be reflected while other light can be reflected by the cathode electrode CAT placed on the side wall of the protrusion portion R downward to the anode electrode ANO, can pass through the color filter CF, and can be emitted to the outside. Light not reflected at the upper surface of the first planarization layer PL1 can pass through the first planarization layer PL1 to proceed downward, then can pass through the color filter CF and be emitted to the outside.

Further, light incident between the first planarization layers PL1 arranged in a plurality of island shapes can be transmitted through the interior of the second planarization layer PL2. Among such light, that light incident on the side wall of the first planarization layer PL1 can be divided into reflected light and refracted light. The reflected lights can travel along the second planarization layer PL2 placed between the first planarization layers PL1, can pass through the color filter CF to be emitted to the outside whereas the refracted light can pass through the first planarization layer PL1, proceed downward, pass through the color filter CF, and then be emitted to the outside.

In order to guide light to be totally reflected at the side wall of the first planarization layer PL1 along the second planarization layer PL2, it is useful for the first planarization layer PL1 to have a vertical rectangular shape in a cross-sectional view or perhaps the cross-sectional shape of the first planarization layer PL1 can have a tapered shape (or positive tapered shape) or a reverse-tapered shape (or negative tapered shape). It is also useful for the slope angle of the side wall of the first planarization layer PL1 to be between 85 degree (in the situation of a positive tapered shape) to 95 degree (in the situation of a negative tapered shape).

Further, in order to ensure that any light be totally reflected from the upper surface of the first planarization layer PL1 towards the cathode electrode CAT deposited on the side wall of the protrusion portion R, and then directed downward, it is advantageous for the first planarization layer PL1 to be arranged at a certain distance from the inclined side wall of the protrusion portion R to the inner area of the anode electrode ANO. For example, it is advantageous that the first planarization layer PL1, especially the first planarization layer PL1 disposed at the outermost edge, to be disposed at a certain gap G from the edge of the anode electrode ANO toward the inside area of the anode electrode ANO.

Also, the size, the shape, and the arrangement interval of the first planarization layer PL1 can be configured in various ways by taking into consideration the refractive indexes of the first planarization layer PL1 and the second planarization layer PL2, and the transmittance for the wavelength of the color light provided from the corresponding pixel. For one example, as shown in FIG. 10, a structure in a plan view can be formed in which a plurality of linear segments of the first planarization layer PL1 extending in a horizontal direction (X-axis direction) can be arranged in a vertical direction (Y-axis direction). For another example, a structure in a plan view can be formed in which a plurality of linear segments of the first planarization layer PL1 extending in a vertical direction (Y-axis direction) can be arranged in a horizontal direction (X-axis direction). For still another example, a structure in a plan view can be formed in which a plurality of the first planarization layer PL1 having square shapes can be arranged in a matrix manner.

Still further, other patterns of the first planarization layer PL1 can be implemented. For example, as discussed above with respect to the second planarization layer PL2 of the fourth embodiment, as might be seen in plan view, the first planarization layer PL1 may take the form of circles, "T" shapes, "V" shapes, "X" shapes, "0" shapes (i.e., cylinders), "L" shapes, equilateral crosses, star shaped, hex shaped, or any combination thereof. In addition, in various examples, different color pixels can employ different shaped patterns of the first planarization layer PL1, patterns of the first planarization layer PL1 having the same shape but of different sizes, and patterns of the same shape but of different arrangements or densities. For example, a plan view pattern of first planarization layers PL1 for red pixels can be an array of 10-by-5 circles while a plan view pattern of first planarization layers PL1 for blue pixels can be an array of 6-by-3 circles of the same or different size.

In view of the structures described above, the fifth embodiment can provide a bottom emission type light emitting display device having an enhanced light extraction efficiency due to the micro mirror structure as light that would otherwise be diminished at the middle portions of the anode electrode ANO assuming the second planarization layer PL2 has a refractive index the same as or not so different from the refractive index of the anode electrode ANO. Accordingly, the light emitting display device according to the fifth embodiment can have higher luminance with the same power consumption. Also, since the power consumption required to provide the same luminance (or brightness) can be lowered, the light emitting display device according to the fifth embodiment can be driven with low power consumption. In addition, for the fifth embodiment, by extracting lights in the vertical direction of the substrate 110 through the space between the first planarization layer PL1 having a lower refractive index and arranged in the island shapes within the second planarization layer PL2 having a higher refractive index, the luminance of the extracted lights can be concentrated to the frontal direction.

### <Sixth Embodiment>

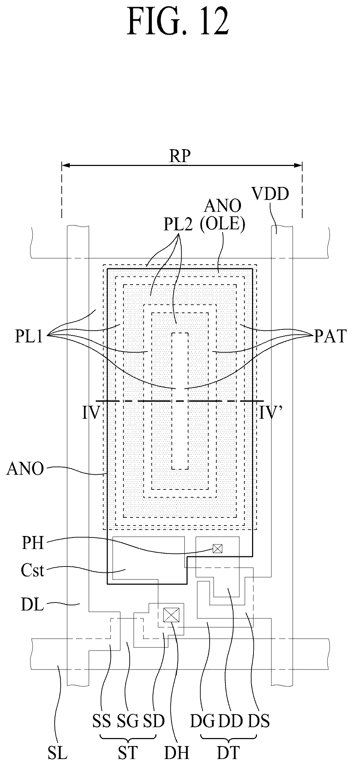

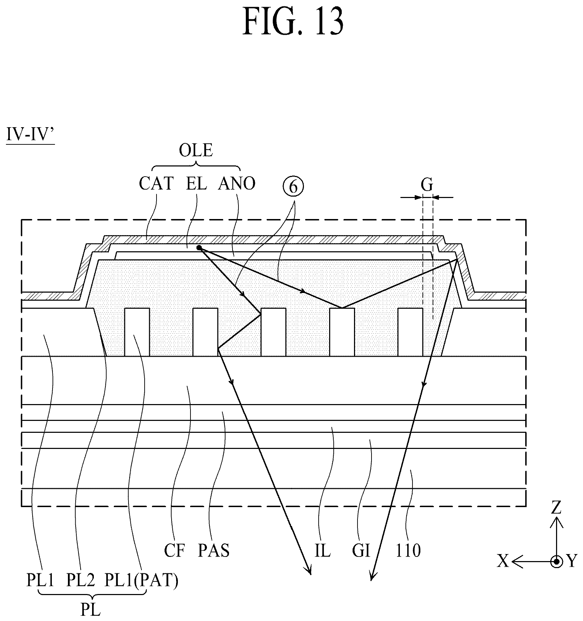

Hereinafter, referring to FIGS. 12 and 13, a light emitting display device according to a sixth embodiment will be explained. FIG. 12 is an enlarged plan view illustrating a structure of a light emitting display device according to a sixth embodiment. FIG. 13 is an enlarged cross-sectional view, taken along line IV-IV' of FIG. 12, illustrating a structure of a light emitting display device according to the sixth embodiment. Referring to FIGS. 12 and 13, a light emitting display device according to a sixth embodiment can include a gate insulating layer GI, an intermediate insulating layer IL, and a passivation layer PAS sequentially deposited on a substrate 110. Further, a color filter CF can be deposited on the passivation layer PAS, and a planarization layer PL can be deposited on the color filter CF. Between the passivation layer PAS and the substrate 110, the switching thin film transistor ST and the driving thin film transistor DT can be formed as shown in FIG. 4. Also, a light emitting diode OLE can be formed on the planarization layer PL with the light emitting diode OLE including an anode electrode ANO, an emission layer EL, and a cathode electrode CAT.

As is shown in FIGS. 12 and 13, the planarization layer PL can include a first planarization layer PL1 and a second planarization layer PL2 with the first planarization layer PL1 stacked on the color filter CF according to a predetermined thickness. Accordingly, at the area under the anode electrode ANO, a plurality of patterns PAT of the first planarization layer PL1 formed as the island shapes can be arranged on the color filter CF with a predetermined distance. At the area between the anode electrode ANO and neighboring anode electrode ANO, the first planarization layer PL1 can be continuously deposited. The plurality of patterns PAT can refer to the arrangement in which the first planarization layers PL1 patterned to the island shapes are arrayed. The patterns PAT of the first planarization layer PL1 can have a plurality of line segments arrayed within the anode electrode ANO, in a plan view. The patterns PAT can include at least two line-segments disposed near to the edge side of the anode electrode ANO. In addition, at least one line-segment of the first planarization layer PL1 can be further disposed between the at least two line-segments. For example, the patterns PAT of the first planarization layer PL1 can have a plurality of rectangular rings arranged concentrically within the anode electrode ANO. In FIG. 12, patterns PAT can include two rectangular rings arranged concentrically and one rectangular segment at the center position of the two rectangular rings.

Also, the second planarization layer PL2 can completely cover the patterns PAT on the first planarization layer PL1, and can be deposited to have a shape that protrudes with a predetermined height above the first planarization layer PL1. The second planarization layer PL2 can be arranged corresponding to the emission area where the anode electrode ANO is formed. For example, the second planarization layer PL2 can correspond to the protrusion portion R explained in the fifth embodiment. Therefore, it can be explained as a structure in which the first planarization layer PL1 can be distributed in the island shapes in the inner region of the second planarization layer PL2. In addition, the first planarization layer PL1 can be arranged on both outer sides of the second planarization layer PL2, i.e., on the outer side of the anode electrode ANO.

In addition, an anode electrode ANO can be formed on the upper surface of the second planarization layer PL2, and an emission layer EL and a cathode electrode CAT can be sequentially stacked on the anode electrode ANO. The emission layer EL and the cathode electrode CAT can be deposited as covering the first planarization layer PL1 and the second planarization layer PL2. Also, the light emitting display device according to the sixth embodiment can have a structure in which the second planarization layer PL2 can cover the first planarization layer PL1. In detail, the plurality of patterns PAT of the first planarization layer PL1 can be arranged with a plurality of island shapes under the anode electrode ANO. For example, among the plurality of patterns PAT, one pattern PAT arranged at the outermost edge can be placed at a certain gap G from the edge of the anode electrode ANO toward the inside of the anode electrode ANO. Further, the second planarization layer PL2 can be formed to completely cover the plurality of patterns PAT of the first planarization layer PL1. Therefore, the space between the plurality of patterns PAT can be filled with the second planarization layer PL2.

Here, the patterns PAT can have the same height as the first planarization layer PL1 disposed at the out of the anode electrode ANO. That is, a topmost surface of the patterns PAT may be level with the upper surface of the flat portion of the first planarization layer PL1. However, the present disclosure is not limited thereto, and the patterns PAT can have a height higher or lower than the height of the first planarization layer PL1 disposed at the out of the anode electrode ANO. Also, the second planarization layer PL2 can have a refractive index higher than that of the first planarization layer PL1. For example, the first planarization layer PL1 can be made of a transparent organic material having a refractive index in range of 1.3 to 1.5 while the second planarization layer PL2 can be made of a transparent organic material having a refractive index having a refractive index the same as or as much as 0.2 lower than the anode electrode ANO, and higher than that of the first planarization layer PL1. Under this condition, the light provided from the emission layer EL can emitted in the same way as optical path ⑥.

Also, the light provided from the emission layer EL can be radiated downward 180 degrees in a situation where the anode electrode ANO is made of a transparent conductive material, and the second planarization layer PL2 has a refractive index similar to that of the anode electrode ANO. In this situation, light passing through the anode electrode ANO can pass through the second planarization layer PL2.

In addition, at the lower portion of the second planarization layer PL2, the plurality of patterns PAT of the first planarization layer PL1 can be disposed as a plurality of island shapes. Among light incident onto the upper surface of the patterns PAT of first planarization layer PL1, at least some light can be reflected. The reflected light can be reflected by the cathode electrode CAT placed on the side wall of the second planarization layer PL2, can proceed to the lower direction of the anode electrode ANO, can pass through the color filter CF, and can be emitted to the outside. Light that is not reflected at the upper surface of the first planarization layer PL1 can pass through the first planarization layer PL1, can proceed downward, can pass through the color filter CF, and can be emitted to the outside.

Further, light incident between the patterns PAT arranged in a plurality of island shapes can be transmitted through the interior of the second planarization layer PL2. Among such light, light incident on the side wall of the patterns PAT can be divided into reflected lights and refracted lights. The reflected lights can travel along the second planarization layer PL2 placed between the patterns PAT, can pass through the color filter CF, and can be emitted to the outside. The refracted lights can pass through the patterns PAT, can proceed downward, can pass through the color filter CF and can be emitted to the outside.

In order to guide light satisfying a reflection condition at the side wall of the patterns PAT along the second planarization layer PL2, it is advantageous for the patterns PAT to have a vertical rectangular shape in a cross-sectional view. However, the cross-sectional shape of the patterns PAT can also have a tapered shape (or positive tapered shape) or a reverse-tapered shape (or negative tapered shape). In such instances, the slope angle of the side wall of the patterns PAT can be between 85 degree (in the situation of a positive tapered shape) to 95 degree (in the situation of a negative tapered shape). Further, in order to ensure that light reflected from the upper surface of the patterns PAT is also reflected by the cathode electrode CAT deposited on the side wall of the second planarization layer PL2 and then directed to the lower direction of the anode electrode ANO of the corresponding pixel, the patterns PAT can be arranged at a certain distance (or gap) G from the inclined side wall of the second planarization layer PL2 to the inner area of the anode electrode ANO.

Also, the size, the shape, and the arrangement interval of the patterns PAT can be configured in various ways by taking into consideration the refractive indexes of the patterns PAT and the second planarization layer PL2, and the transmittance for the wavelength of the color light provided from the corresponding pixel. For example, the patterns PAT can be disposed as any one arrangement type among the arrangement types of the second planarization layer PL2 shown in FIGS. 8-10.

Thus, the sixth embodiment can provide a bottom emission type light emitting display device having an enhanced light extraction efficiency due to the micro mirror structure. In addition, the light emitting display device according to the sixth embodiment can extract the lights that would otherwise be diminished at the middle portions of the anode electrode ANO assuming the second planarization layer PL2 has a refractive index the same as or not so different from that of the anode electrode ANO. Accordingly, the light emitting display device according to the sixth embodiment can have higher luminance with the same power consumption. In other words, since the power consumption required to provide the same luminance (or brightness) can be lowered, the light emitting display device according to the sixth embodiment can be driven with low power consumption. In addition, for the sixth embodiment, by extracting lights in the vertical direction of the substrate 110 through the space between the plurality of patterns PAT of the first planarization layer PL1 having a lower refractive index and arranged in the island shapes within the second planarization layer PL2 having a higher refractive index, the luminance of the extracted lights can be concentrated to the frontal direction.

Still further, in the descriptions from the first embodiment to the fifth embodiment, the light emitting display device can have a bank-less structure in which the bank for defining the emission area by covering the circumferential edges of the anode electrode ANO is not formed. Here, the bank can be an insulating layer for defining the emission area by covering the circumferential edges of the anode electrode ANO to expose the middle portion of the anode electrode ANO. The bank can be called a 'pixel defining layer.' In other embodiments, however, the light emitting display device according to the present disclosure may not have bank at all. However, the present disclosure is not limited thereto and the bank can be disposed at the upper side and lower side of the pixel where the driving element is disposed with a possible exception at the left side and the right side of the pixel. Further, for the situation of having bank surrounding the pixel, the structure described in the present disclosure can be applied. The present disclosure mainly describes the bank-less structure that can be advantageous for low-power operation and can ensure the maximum aperture ratio.

In summary, a light emitting display device according to at least one embodiment of the present disclosure includes: a substrate, a planarization layer, a plurality of pillars, an anode electrode, an emission layer and a cathode electrode. The substrate includes a plurality of pixels. The planarization layer is disposed on the substrate, and includes a flat portion having a predetermined thickness and a protrusion portion extruded upward from the flat portion. The plurality of pillars is arrayed with a predetermined gap inside the protrusion portion. The anode electrode is disposed on an upper surface of the protrusion portion. The emission layer is disposed on the anode electrode. The cathode electrode is disposed on the emission layer.

In an example, the emission layer covers an upper surface of the planarization layer, a sidewall of the protrusion portion, and an upper surface of the anode electrode. Also, the cathode electrode is in surface contact with the emission layer in this example. In another example, the anode electrode is contact with an upper surface of the planarization layer and upper surfaces of the plurality of pillars, the plurality of pillars has a first refractive index similar to the anode electrode, and the planarization layer has a second refractive index lower than the first refractive index. In yet another example, each of the plurality of pillars has a length same with the thickness of the protrusion portion.

In still another example, the protrusion portion of the planarization layer overlaps upper surfaces of the plurality of pillars and is disposed between the plurality of pillars while the anode electrode contacts an upper surface of the planarization layer. In this example, the planarization layer has a first refractive index similar to the anode electrode, and the plurality of pillars has a second refractive index lower than the first refractive index. In yet another example, each of the plurality of pillars has a length smaller than the thickness of the protrusion portion of the planarization layer.

In an example, the planarization layer includes: a first planarization layer including the flat portion and the plurality of pillars; and a second planarization layer corresponding to the protrusion portion. Also, the second planarization layer has a first refractive index similar to the anode electrode, and the first planarization layer has a second refractive index lower than the first refractive index.

In another example, the first planarization layer has a first height, and the second planarization layer has a second height higher than the first height. Also, the second planarization layer covers a side wall of the flat portion and the plurality of the pillars. In still another example, each of the plurality of pillars includes an upper end surface and a lower end surface. In this example, the upper end surface is the same size as the lower end surface. In yet another example, each of the plurality of pillars includes an upper end surface and a lower end surface, and the upper end surface has a size smaller than the lower end surface. In an example, each of the plurality of pillars includes an upper end surface and a lower end surface, and the upper end surface has a size larger than the lower end surface.

In an example, the light emitting display device further includes: a color filter between the planarization layer and the substrate; and a driving element layer between the color filter and the substrate. In an example, each of the plurality of pillars includes a rectangular shape having a length and a width within the pixel in a plan view, and the plurality of pillars are arranged at a certain distance apart from each other. In an example, each of the plurality of pillars includes a rectangular ring shape with a width within the pixel in a plan view.

In an example, each of the plurality of pillars includes a square shape having a length and a width within the pixel in a plan view, and the plurality of pillars are arranged in a matrix manner with a predetermined gap. The various embodiments described above can be combined to provide further embodiments.

The following numbered examples pertain to embodiments of the present disclosure.

Example 1: A light emitting display device comprising: a substrate including a plurality of pixels; a planarization layer on the substrate and having a first portion surrounding a plurality of pillar-shaped second portions; an anode electrode on the planarization layer; an emission layer on the anode electrode; and a cathode electrode on the emission layer, wherein the pillar-shaped second portions of the planarization layer have a refractive index corresponding to a refractive index of the anode electrode such that light transmitted by the emission layer is reflected within a corresponding pillar towards the substrate, and wherein the refractive index of the pillar-shaped second portions is greater than a refractive index of the first portion.

Example 2: The light emitting display device according to Example 1, wherein the planarization layer includes a flat portion and a protrusion portion protruding from the flat portion, wherein the anode electrode extends along an upper surface of the protrusion portion without extending beyond edges of the protrusion portion, wherein the emission layer covers the anode electrode and extends onto the flat portion of the planarization layer, wherein the cathode electrode covers the emission layer and extends onto the flat portion of the planarization layer, and wherein the cathode electrode is in surface contact with the emission layer.

Example 3: The light emitting display device according to Example 2, wherein the anode electrode contacts an upper surface of the planarization layer and upper surfaces of the pillar-shaped second portions.

Example 4: The light emitting display device according to Example 2 or 3, wherein each of the pillar-shaped second portions has a same length as a thickness of the protrusion portion of the planarization layer.

Example 5: The light emitting display device according to Example 2 or 3, wherein the protrusion portion of the planarization layer overlaps upper surfaces of the pillar-shaped second portions.

Example 6: The light emitting display device according to any of Examples 2, 3, or 5 wherein each of the pillar-shaped second portions has a length smaller than a thickness of the protrusion portion of the planarization layer.

Example 7: The light emitting display device according to any of Examples 1 to 6, wherein each of the pillar-shaped second portions includes an upper end surface and a lower end surface, the upper end surface having a size same as the lower end surface.

Example 8: The light emitting display device according to any of Examples 1 to 6, wherein each of the pillar-shaped second portions includes an upper end surface and a lower end surface, the upper end surface having a size smaller than the lower end surface.

Example 9: The light emitting display device according to any of Examples 1 to 6, wherein each of the pillar-shaped second portions includes an upper end surface and a lower end surface, the upper end surface having a size larger than the lower end surface.

Example 10: The light emitting display device according to Example 9, further comprising: a color filter between the planarization layer and the substrate; and a driving element layer between the color filter and the substrate.

Example 11: The light emitting display device according to any of Examples 1 to 10, wherein each of the pillar-shaped second portions includes a rectangular shape having a length and a width within a pixel in a plan view, and the pillar-shaped second portions are arranged apart from each other.

Example 12: The light emitting display device according to any of Examples 1 to 10, wherein each of the pillar-shaped second portions includes a rectangular ring shape with a width within a pixel in a plan view.

Example 13: The light emitting display device according to any of Examples 1 to 10, wherein each of the pillar-shaped second portions includes a square shape having a length and a width within a pixel in a plan view, and the pillar-shaped second portions are arranged in a matrix with a predetermined gap.

Example 14: A light emitting display device comprising: a substrate including a plurality of pixels; a transparent planarization layer on the substrate and including a flat portion having a predetermined thickness and a protrusion portion extruded upward from an upper surface of the flat portion, wherein the transparent planarization layer has a first portion with a first refractive index and a second portion with a second refractive index; a light emitting diode configured to emit light comprising: an anode electrode on an upper surface of the protrusion portion; an emission layer on the anode electrode; and a reflective cathode electrode on the emission layer, wherein the anode electrode is over (e.g., directly over) the first portion and the second portion, and wherein a refractive index of the anode electrode is closer to the second refractive index than the first refractive index.

Example 15: The light emitting display device according to Example 14, wherein the second portion of the transparent planarization layer includes a plurality of pillars overlapping the protrusion portion and spaced apart from one another.

Example 16: The light emitting display device according to Example 15, wherein the anode electrode is in direct contact with an upper surface of the first portion and an upper surface of the second portion of the transparent planarization layer.

Example 17: The light emitting display device according to Example 15, wherein the second portion above the plurality of pillars directly contacts the anode electrode and separates the anode electrode from the first portion, and wherein the anode electrode is spaced apart from the first portion of the transparent planarization layer.

Example 18: The light emitting display device according to Example 17, wherein a topmost surface of the first portion is above the upper surface of the flat portion.

Example 19: The light emitting display device according to Example 17, wherein a topmost surface of the first portion is level with the upper surface of the flat portion.

Example 20: The light emitting display device according to any of Examples 14 to 19, further comprising: a transistor electrically connected to the anode electrode; and a color filter disposed between the substrate and the transparent planarization layer, wherein the color filter directly contacts the first portion and the second portion of the transparent planarization layer.

## Claims

1. A light emitting display device comprising:
a substrate (110) including a plurality of pixels (P);
a planarization layer (PL) on the substrate (110) and having a first portion (PL1) surrounding a plurality of pillar-shaped second portions (PL2);
an anode electrode (ANO) on the planarization layer (PL);
an emission layer (EL) on the anode electrode (ANO); and
a cathode electrode (CAT) on the emission layer (EL),
wherein the pillar-shaped second portions (PL2) of the planarization layer (PL) have a refractive index corresponding to a refractive index of the anode electrode (ANO) such that light transmitted by the emission layer (EL) is reflected within a corresponding pillar towards the substrate (110), and
wherein the refractive index of the pillar-shaped second portions (PL2) is greater than a refractive index of the first portion (PL1).

2. The light emitting display device according to claim 1, wherein the planarization layer (PL) includes a flat portion (H) and a protrusion portion (R) protruding from the flat portion (H),
wherein the anode electrode (ANO) extends along an upper surface of the protrusion portion (R) without extending beyond edges of the protrusion portion (R),
wherein the emission layer (EL) covers the anode electrode (ANO) and extends onto the flat portion (H) of the planarization layer (PL),
wherein the cathode electrode (CAT) covers the emission layer (EL) and extends onto the flat portion (H) of the planarization layer (PL), and
wherein the cathode electrode (CAT) is in surface contact with the emission layer (EL).

3. The light emitting display device according to claim 2, wherein the anode electrode (ANO) contacts an upper surface of the planarization layer (PL) and upper surfaces of the pillar-shaped second portions (PL2).

4. The light emitting display device according to claim 2 or 3, wherein each of the pillar-shaped second portions (PL2) has a same length as a thickness of the protrusion portion (R) of the planarization layer (PL).

5. The light emitting display device according to claim 2 or 3, wherein the protrusion portion (R) of the planarization layer (PL) overlaps upper surfaces of the pillar-shaped second portions (PL2).

6. The light emitting display device according to any of claims 2, 3 or 5, wherein each of the pillar-shaped second portions (PL2) has a length smaller than a thickness of the protrusion portion (R) of the planarization layer (PL).

7. The light emitting display device according to any of claims 1 to 6, wherein each of the pillar-shaped second portions (PL2) includes an upper end surface and a lower end surface, the upper end surface having a size same as the lower end surface.

8. The light emitting display device according to any of claims 1 to 6, wherein each of the pillar-shaped second portions (PL2) includes an upper end surface and a lower end surface, the upper end surface having a size smaller than the lower end surface.

9. The light emitting display device according to any of claims 1 to 6, wherein each of the pillar-shaped second portions (PL2) includes an upper end surface and a lower end surface, the upper end surface having a size larger than the lower end surface.

10. The light emitting display device according to claim 9, further comprising:
a color filter (CF) between the planarization layer (PL) and the substrate (110); and
a driving element layer between the color filter (CF) and the substrate (110).

11. The light emitting display device according to any of claims 1 to 10, wherein each of the pillar-shaped second portions (PL2) includes a rectangular shape having a length and a width within a pixel (P) in a plan view, and the pillar-shaped second portions (PL2) are arranged apart from each other.

12. The light emitting display device according to any of claims 1 to 10, wherein each of the pillar-shaped second portions (PL2) includes a rectangular ring shape with a width within a pixel (P) in a plan view.

13. The light emitting display device according to any of claims 1 to 10, wherein each of the pillar-shaped second portions (PL2) includes a square shape having a length and a width within a pixel (P) in a plan view, and the pillar-shaped second portions (PL2) are arranged in a matrix with a predetermined gap.

14. A light emitting display device comprising:
a substrate (110) including a plurality of pixels (P);
a transparent planarization layer (PL) on the substrate (110) and including a flat portion (H, H1) having a predetermined thickness and a protrusion portion (R, R1) extruded upward from an upper surface of the flat portion (H), wherein the transparent planarization layer (PL) has a first portion (PL1) with a first refractive index and a second portion (PL2) with a second refractive index;
a light emitting diode (OLE) configured to emit light comprising:
an anode electrode (ANO) on an upper surface of the protrusion portion (R, R1);
an emission layer (EL) on the anode electrode (ANO); and
a reflective cathode electrode (CAT) on the emission layer (EL),
wherein the anode electrode (ANO) is over the first portion (PL1) and the second portion (PL2), and
wherein a refractive index of the anode electrode (ANO) is closer to the second refractive index than the first refractive index.

15. The light emitting display device according to claim 14, wherein the second portion (PL2) of the planarization layer (PL) includes a plurality of pillars (V) overlapping the protrusion portion (R1) and spaced apart from one another,
wherein, preferably:
the anode electrode (ANO) is in direct contact with an upper surface of the first portion (PL1) and an upper surface of the second portion (PL2) of the planarization layer (PL); or
the second portion (PL2) above the plurality of pillars (V) directly contacts the anode electrode (ANO) and separates the anode electrode (ANO) from the first portion (PL1), and
the anode electrode (ANO) is spaced apart from the first portion (PL1) of the planarization layer (PL).
